# EUROPÄISCHE PATENTSCHRIFT

(11) **EP 0 503 456 B1**
(45) Veröffentlichungstag und Bekanntmachung des Hinweises auf die Patenterteilung: **26.10.1994**
(21) Anmeldenummer: 92103670.3
(22) Anmeldetag: 04.03.1992
(51) Int. Cl.: H05K 7/14, H05K 9/00

(54) **Steuergerät mit Mikroprozessor für Mittel- und Hochspannungsschaltanlagen**
Microprocessor controlled apparatus for medium and high voltage voltage switchgear
Appareil de commande à microprocesseur d'installation électrique moyenne et haute tension

(30) Priorität: 11.03.1991 CH 718/91
(43) Veröffentlichungstag der Anmeldung: 16.09.1992
(73) Patentinhaber: GEC Alsthom T&D AG, 5036 Oberentfelden (CH)
(72) Erfinder: Bruggisser, Paul, CH-5603 Staufen (CH); Cimma, Patrick, CH-5034 Rohr (CH); Merz, Peter, CH-5505 Brunegg (CH)
(74) Vertreter: Patentanwälte Schaad, Balass, Menzl & Partner AG

(56) Entgegenhaltungen:
- EP-A- 0 313 955
- DE-A- 2 264 112
- GB-A- 2 221 100
- US-A- 3 675 083

## Beschreibung

Die Erfindung betrifft ein Steuergerät mit Mikroprozessor für Mittel- und Hochspannungsschaltanlagen gemäss dem Oberbegriff von Anspruch 1.

Solche Steuergeräte dienen hauptsächlich der Vorortsteuerung von kleinen Schaltanlagen oder von Teilen einer grösseren Schaltanlagen. Sie Erfassen die Stellungen der zugeordneten Schaltgeräte wie Leistungs-, Trenn- und Erdschalter sowie auch die Messignale der Strom- und Spannungswandler. Aenderungen des Betriebszustandes der Schaltanlage werden angezeigt, zusammen mit der Zeit gespeichert, auf einem Drucker protokolliert oder über Datenverbindungen an übergeordnete oder benachbarte Einheiten weitergeleitet. Dank ihrer eigenen Intelligenz verhindern solche Steuergeräte unzulässige Schalthandlungen und können sie ganze Schaltsequenzen automatisch ablaufen lassen.

Da sie galvanisch über Mess- und Steuerleitungen mit den Antrieben der Schaltgeräte verbunden sind, muss bei solchen Steuergeräten der elektromagnetischen Kompatibilität (EMC) besondere Beachtung geschenkt werden. Ueber die Leitungen werden nicht nur die Nutzsignale, wie Schalterstellungen, Schaltbefehle und analoge Messignale, sondern auch Störspannungen grosser Amplitude und meist sehr hoher Frequenz übertragen. Ohne besondere EMC-Massnahmen können diese Störspannungen nicht nur das korrekte Funktionieren des Mikroprozessorsystemes beeinträchtigen, sondern auch dieses beschädigen oder sogar zerstören. Eine galvanische Trennung mittels handelsüblicher Optokoppler allein hat sich in der Praxis als ungenügend erwiesen.

Es ist üblich, die Leitungen mittels Stecker auf eine gedruckte Schaltung zu führen, welche auch die Optokoppler trägt. Zwischen den Eingangssteckern und den Optokopplern werden spannungsbegrenzende Bauteile wie Kondensatoren, Varistoren und/oder Zenerdioden angeordnet, die Ueberspannungen gegen Gehäuse-Erde ableiten. Da bei dieser aus der Technik der speicherprogrammierbaren Steuerungen stammenden Lösung die Gehäuse-Erde ebenfalls über den Stecker zugeführt werden muss, ergeben sich für die hohen infrage kommenden Frequenzen der Störsignale hohe Impedanzen für die Erdrückleitung. Die Begrenzung der Ueberspannungen ist ungenügend und es sind zusätzliche Begrenzungsmittel beim Eintritt der Leitungen ins Gehäuse erforderlich. Dies ist mit einem enormen zusätzlichen Verdrahtungsaufwand verbunden.

Aus der EP-A1 0 310 589 ist ein Steuergerät bekannt, bei dem die Ueberspannungen an den Leitungen nicht begrenzt werden. Speziell angefertigte Optokoppler mit besonders hoher Spannungsfestigkeit übertragen die Signale zwischen Prozessorsystem und Leitungen. Sie durchdringen die Wand eines Faraday-Käfigs, der nur das Mikroprozessorsystem enthält. Ein speziell angefertigtes Speisegerät für das Mikroprozessorsystem verhindert, dass Ueberspannungen über die Spannungsversorgung zum Mikroprozessorsystem gelangen können. Mit diesem Steuergerät werden die EMC-Probleme gut beherrscht. Wegen der Sonderanfertigung für Optokoppler und Speisegerät ist es aber sehr teuer und aufwendig in der Herstellung.

Aufgabe der Erfindung ist es, ein Steuergerät anzugeben, das aus handelsüblichen Komponenten aufgebaut werden kann, und bei dem die EMC-Probleme ohne grossen Verdrahtungsaufwand beherrscht werden.

Diese Aufgabe wird durch ein Steuergerät mit den kennzeichnenden Merkmalen des Anspruches 1 gelöst.

Anhand der Zeichnungen wird die Erfindung näher erklärt.

Es zeigen:
Die Fig. 1 ein erfindungsgemässes Steuergerät in isometrischer Darstellung, wobei einzelne Teile zum besseren Sichtbarmachen der dahinterliegenden Teile weggelassen wurden;
die Fig. 2 die Rückwand des Steuergerätes von Fig. 1 in isometrischer Darstellung;
die Fig. 3 und 4 in isometrischer Darstellung die Vorderseite bzw. die Rückseite der Filterplatte des Steuergerätes von Fig. 1;
die Fig. 5 und 6 die entsprechenden Layouts der Filterplatte.

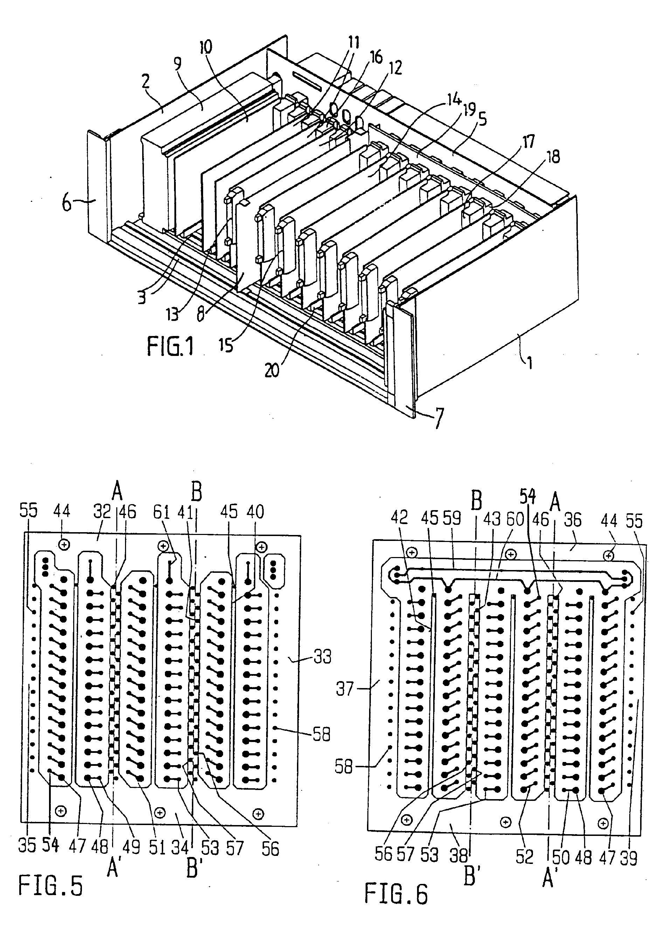

Das Steuergerät der Fig. 1 besteht aus einem Gehäuse der bekannten Rack-Bauart. Es besteht aus zwei metallischen Seitenwänden 1, 2, die mit ebenfalls metallischen Profilschienen 3 miteinander gut leitend, z.B durch Verschrauben, verbunden sind. Ein gleicher Satz von Profilschienen verbindet auf analoge Art die beiden Seitenwände 1, 2 auch auf der Oberseite. Sie sind in der Fig. 1 der Uebersichtlichkeit halber weggelassen worden. An den Vorderkanten der Seitenwände 1, 2 angeschraubte Winkel 6, 7 dienen zur Befestigung des Gehäuses in einem passenden Gestell. Auf der Vorderseite ist eine (in der Fig. 1 nicht gezeigte) Frontplatte angebracht, in der Anzeigen (z.B. Kontrollampen oder Zeigerinstrumente) und Befehlsgeräte (z.B. Drucktasten) befestigt sind. Eine auf die (nicht sichtbaren) hinteren Profilschienen geschraubte metallische Rückplatte 5 schliesst das Gehäuse hinten ab. Desgleichen sind metallische Abdeckplatten von oben (in Fig. 1 nicht gezeigt) und unten (nicht sichtbar) gut leitend auf die Profilschienen geschraubt. Das Gehäuse bildet dank der gut leitenden Verbindungen zwischen seinen Aussenwänden einen Faraday-Käfig.

Eine leitende Abschirmplatte 8 trennt diesen Faraday-Käfig in zwei Teile. Im rechten Teil befinden sich die Schnittstellen zu den Steuer- und Messleitungen, im linken Teil ist das eigentliche Mikroprozessorsystem untergebracht, bestehend aus einem Netzgerät 9, das die zum Betrieb des Steuergerätes benötigten Hilfsspannungen liefert, einer Prozessorkarte 10, auf der sich u.a. der Prozessor, ein Programm- und Datenspeicher und eine Kalenderuhr befindet, und mehreren Zusatzkarten 11, 12. Letztere können zum Beispiel Schnittstellen für die externe Datenkommunikation oder Zusatzspeicher enthalten. Die Zusatzkarte 12 stellt die Verbindung zu den sich im rechten Teil befindenden Schnittstellenkarten 14 für die Mess- und Steuerleitungen, wie auch zu den sich in der Frontplatte befindenden Anzeigen und Befehlsgeräten sicher. Diese Verbindung wird durch ein Flachkabel hergestellt, das mit entsprechenden Zwischensteckern auf den sich an der Vorderkante der Zusatzkarte 12 befindenden Mehrfachstecker 13 und auf analoge Mehrfachstecker 15 an der Vorderkante der Schnittstellenkarten 14 und schliesslich auf einen sich auf der Frontplatte befindenden Mehrfachstecker gesteckt wird.

Ein sich unmittelbar vor der Rückwand befindender Bus mit Steckverbindungen 16 sorgt für die Verbindung der Prozessorkarte 10 mit den Zusatzkarten 11, 12.

Die Schnittstellenkarten 14 sind z.B. Eingangskarten für acht analoge Messignale, wie Strom- oder Spannungssignale, oder für 15 digitale Eingänge, wie Schalterstellungen oder Fehlermeldungen, oder auch Ausgangskarten mit z.B. acht potentialfreien Relaiskontakten.

Gemeinsam an allen Schnittstellenkarten 14 ist, dass sie aufgeteilt sind in einen vorne liegenden Teil, der galvanisch mit dem Prozessorteil verbunden ist, und einen hinteren Teil, der galvanisch mit den Mess- und Steuerleitungen verbunden ist. Zwischen diesen beiden Teilen sorgen Optokoppler für die galvanische Trennung.

Die Schnittstellenkarten 14 sitzen in unteren und oberen (nicht gezeigten) Führungsschienen 20 und sind mit zweireihigen Mehrfachsteckern 17 mit je Reihe 16 Kontaktstücken versehen, die in dazu passende Stecker 18 eingesteckt sind. Diese sind auf einer Filterplatte 19 befestigt. Die Filterplatte 19 ist oben und unten mit Profilschienen 3 verschraubt. Links ist sie mittels sogenannter Hochfrequenzdichtungen aus leitendem Elastomer mit der Abschirmplatte 8, rechts mit einer ebensolchen Dichtung mit der rechten Seitenwand 1 elektrisch gut leitend verbunden.

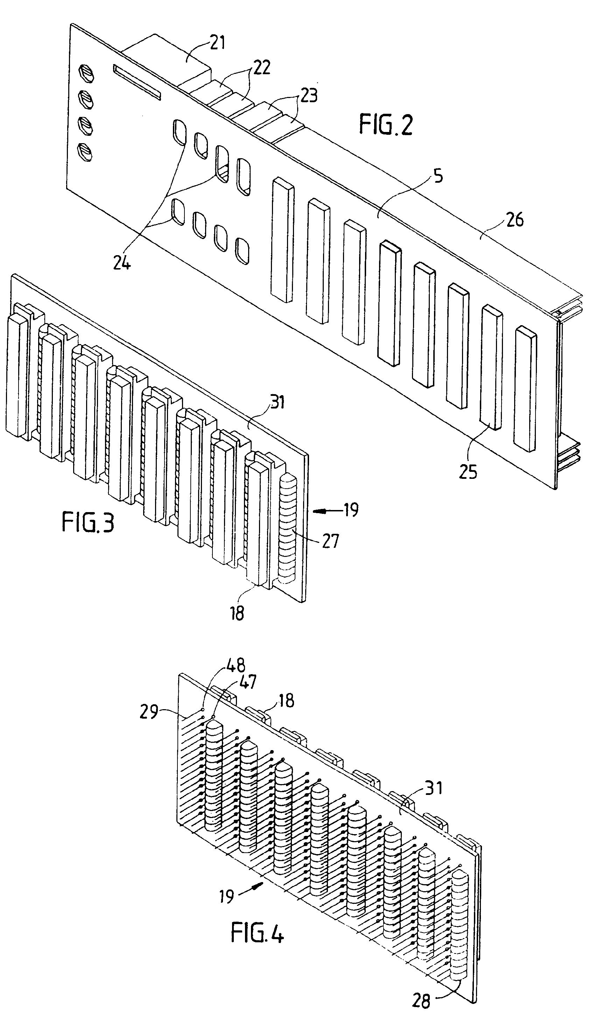

Der Aufbau der Rückplatte 5 geht aus Fig. 2 hervor. Auf der linken Seite, hinter dem Prozessorteil, befinden sich die Anschlussklemmen und ein Eingangsfilter 21 für die Speisespannung des Steuergerätes. Daneben befinden sich Steckbuchsen 22, 23 für serielle und parallele Datenkommunikationsleitungen. Durch Oeffnungen 24 können die Verbindungskabel zwischen den Steckbuchsen 22, 23 und den zugehörigen Zusatzkarten 11 durchgezogen werden. Hinter dem rechten Teil des Steuergerätes, das heisst hinter der Filterplatte 19, sind in die Rückplatte 5 isolierende Steckergehäuse 25 eingelassen, die mit den Stecken 18 fluchten. In diese Steckergehäuse 25 sind Durchgangsöffnungen angebracht, in welche von hinten Crimpkontaktstücke eingesteckt werden, die auf die Mess- und Steuerleitungen aufgepresst sind. Dank einer an den Crimpkontaktstücken angebrachten, wie ein Widerhaken wirkenden Lasche können einmal eingeführte Crimpkontaktstücke nur noch mit einem speziellen Werkzeug wieder aus den Durchgangsöffnungen entfernt werden.

In isolierenden Profilen eingelassene Stromschienen 26 dienen zur Herstellung von Querverbindungen zwischen einzelnen Crimpkontaktstücken.

Der Aufbau der Filterplatte geht aus den Fig. 3 und 4 hervor. Die nach vorne gerichteten Kontaktstücke der Stecker 18, die mit dazu passenden Kontaktstücken der Mehrfachstecker 17 beim Einführen der Schnittstellenkarten 14 Kontakt machen, sind nach hinten durch weit vorstehende Stifte 29 verlängert. Diese werden beim Montieren der Stecker 18 durch durchkontaktierte Bohrungen 47, 48 in der als beidseitig kupferkaschierte gedruckte Schaltung ausgeführten Grundplatte 31 gepresst. Die Durchgangsöffnungen der Steckergehäuse 25 auf der Rückplatte 5 fluchten mit den einzelnen Kontakten der Stecker 18. Beim Anbringen der Rückplatte 5 mit den eingesteckten Crimpkontaktstücken werden deshalb alle Mess- und Steuerleitungen gleichzeitig an die zugehörigen Schnittstellenkarten 14 angeschlossen. Dank diesem Umstand kann ein gestörtes Steuergerät rasch durch ein Ersatzgerät ausgewechselt werden, indem die Rückplatte 5 des gestörten Gerätes an das Ersatzgerät montiert wird. Die gesamte Verdrahtung der Mess- und Steuerkreise bleibt dabei erhalten.

Rechts von jedem Stecker 18 ist auf der Vorderseite je eine Reihe aus 15 Störschutzkondensatoren 27 in die Grundplatte 31 eingelötet. Eine gleiche Reihe von Störschutzkondensatoren 28 befindet sich auf der Rückseite der Grundplatte 31 rechts der rechten Reihe von Stiften 29 eines Steckers 18. Diese Reihe von Störschutzkondensatoren 28 ist um eine halbe Teilung gegenüber der Reihe auf der Vorderseite nach oben versetzt.

Auf den Fig. 5 und 6 sind die Layouts der beiden Seiten der Grundplatte für eine Filterplatte mit nur drei Steckern 18 gezeigt. Für eine Grundplatte für eine grössere Zahl von Steckern 18, z.B. für die Grundplatte 31 der in den Fig. 3 und 4 gezeigten Filterplatte 19 mit acht Steckern 18 wird nach Bedarf der Bereich zwischen den Linien A-A' und B-B' reproduziert. Man erkennt, dass bis auf den obersten Viertel die Layouts der Vorderseite (Fig. 5) und der Rückseite (Fig. 6) spiegelbildlich sind.

Sowohl auf der Vorder- wie auch auf der Rückseite ist allen vier Rändern nach je eine breite Leiterbahn 32, 33, 34, 35 bzw. 36, 37, 38, 39 angelegt. Diese Leiterbahnen sind blank verzinnt. Die obere und untere Leiterbahn 32, 34 der Vorderseite liegt im eingebauten Zustand an Profilschienen 3 des Gehäuses an. Schrauben, die durch die durchkontaktierten Bohrungen 44 geführt sind, bewirken mit ihrer Presskraft einen guten niederohmigen Kontakt mit den Profilschienen 3. Die oberen und unteren Leiterbahnen 32, 34 der Vorderseite sind mit weiteren Leiterbahnen 40 und 41 miteinander sprossenartig verbunden. Den Leiterbahnen 40 und 41 der Vorderseite entsprechen auf der Rückseite die Leiterbahnen 42 und 43. Diese münden unten in die Randleiterbahn 38 und enden oben an durchkontaktierten Bohrungen 45 und 46. Die Leiterbahnen 32 bis 43 bilden zusammen ein engmaschiges Gitter das ringsum in gutem Kontakt mit dem Gehäuse des Steuergerätes steht. Dieses Gitter bildet eine gute Abschirmung gegen von den Mess- und Steuerleitungen abgestrahlte Störfelder.

Links und rechts der Leiterbahnen 40 und 42 ist je eine Reihe von 16 durchkontaktierten Bohrungen 47, 48 gebohrt, in welche die Stiften 29 der Stecker 18 eingepresst werden. Von den Bohrungen 48 aus führen horizontale Leiterbahnen 49, 50 zu weiteren durchkontaktierten Bohrungen 53, in die die einen Anschlüsse der Störschutzkondensatoren 27 von der Vorderseite her eingelötet werden. Analog führen von den Bohrungen 47 aus schräge Leiterbahnen 51, 52 zu Bohrungen 54, welche die einen Anschlüsse der Störschutzkondensatoren 28 der Rückseite aufnehmen. Die anderen Anschlüsse der Störschutzkondensatoren 27 und 28 werden in durchkontaktierte Bohrungen 55, 56, 57 und 58 über die Leiterbahnen 33, 37; 41, 43; 35, 39 an Gehäuse-Erde angeschlossen. Dank der gewählten Anordnung der Leiterbahnen ergeben sich sehr kurze Verbindungen sowohl zwischen den Mess- und Steuerleitungen und den Störschutzkondensatoren 27, 28, als auch zwischen den Störschutzkondensatoren 27, 28 und der Gehäuse-Erde, Verbindungen, die wegen der doppelten Führung auf beiden Seiten der Grundplatte 31 einen grossen Querschnitt, d.h. geringen Widerstand, und eine geringe Induktivität aufweisen.

Nahe dem oberen Rand verlaufen auf der Rückseite zwei Leiterbahnen 59, 60, an die eine Gleichspannung von z.B. 24 V mittels eines am einen Ende der Leiterbahnen 59, 60 angelöteten Steckers über ein Kabel zugeführt wird. Diese Gleichspannung dient zur Versorgung der Spulen von sich auf Schnittstellenkarten 14 befindenden Ausgangsrelais oder, im Falle einer Schnittstellenkarte mit analogen Eingängen, für die Versorgung der A/D-Wandler. Die untere Leiterbahn 60 ist direkt, die obere 59 unter Zwischenschaltung der Leiterbahnen 61, auf die Bohrungen für die obersten beiden Stifte 29 der Stecker 18 geführt.

Das ganze Steuergerät kann zum grössten Teil aus handelsüblichen Komponenten zusammengestellt werden. So sind z.B. die Prozessorkarte 10, die Zusatzkarten 11, 12 und die Schnittstellenkarten 14 sogenannte Europakarten. Das Netzgerät 9 ist in der hier gebrauchten Form ebenfalls handelsüblich. Die Stecker 18 und 25 sind genormte Stecker nach DIN 41612, und selbstverständlich ist das Gehäuse aus handelsüblichen Teilen zusammengesetzt. Die Grundplatte 31 ist wohl nicht handelsüblich, sie kann als beidseitig kupferkaschierte gedruckte Schaltung jedoch mit in der Elektronik üblichen Verfahren ohne grossen Aufwand hergestellt und bestückt werden.

## Patentansprüche

1. Steuergerät mit Mikroprozessor für Mittel- und Hochspannungsschaltanlagen, das in einem als Faraday-Käfig ausgebildeten Gehäuse eingebaut ist und über elektrische Mess- und Steuerleitungen mit den Antrieben der Schaltgeräte und den Messwandlern der Schaltanlage verbunden ist, wobei die Leitungen mittels Optokopplern vom Mikroprozessorsystem galvanisch getrennt sind, **durch folgende Merkmale gekennzeichnet:**
a) die Leitungen sind auf der einen Seite einer aus einer gedruckten Schaltung (31) bestehenden Filterplatte (19) auf diese durchdringende, in Reihen angeordnete Stifte (29) geführt;
b) auf der anderen Seite der Filterplatte (19) sind Stecker (18) mit Reihen von Kontaktstücken angebracht, welche Kontaktstücke je mit einem Stift (29) fluchten und mit ihm elektrisch verbunden sind;
c) in diese Stecker (18) sind Schnittstellenkarten (14) mit einer ersten Stirnseite eingesteckt, welche die Optokoppler tragen und an der gegenüberliegenden zweiten Stirnseite über einen Vielfachstecker (15) mit einem zum Prozessor führenden Bus verbunden sind;
d) die Filterplatte (19) ist an ihrem ganzen Umfang mit einer blanken Randleiterbahn (32, 33, 34, 35; 36, 37, 38,39) versehen, die auf ihrer ganzen Länge das Gehäuse kontaktiert;
e) zwischen jeweils zwei Reihen von Stiften (29) verläuft je eine weitere Leiterbahn (40, 41; 42, 43), die an ihren beiden Enden mit der Randleiterbahn (32, 33, 34, 35; 36, 37, 38,39) verbunden ist;
f) jeder der Stifte (29) einer Reihe ist mittels je einer Leiterbahn (49, 50; 51, 52) der Filterplatte (19) mit den ersten Anschlüssen von Ueberspannungsbegrenzern (27, 28) verbunden, die in zu den Reihen der Stifte (29) parallel verlaufenden Reihen angeordnet sind und deren zweite Anschlüsse unmittelbar oder über eine der weiteren Leiterbahnen (41, 43) mit der Randleiterbahn (32, 33, 34, 35; 36, 37, 38, 39) verbunden sind.

2. Steuergerät nach Anspruch 1, **dadurch gekennzeichnet**, dass die Ueberspannungsbegrenzer (27, 28) Kondensatoren sind.

3. Steuergerät nach Anspruch 1 oder 2, **dadurch gekennzeichnet**, dass die Stifte (29), die Kontaktstücke und das isolierende Gehäuse jedes Steckers (18) miteinander untrennbar verbunden sind, so dass die Stifte (29) zugleich das Befestigungsmittel für die Stecker (18) an der Filterplatte (19) bilden.

4. Steuergerät nach einem der Ansprüche 1 bis 3, **dadurch gekennzeichnet**, dass die Stecker (18) zwei Reihen von Kontaktstücken haben, und die den ersten Reihen von Kontaktstücken zugeordneten Reihen von Ueberspannungsbegrenzern (27) auf einer Seite der Filterplatte (19) angeordnet sind, die den anderen Reihen von Kontaktstücken zugeordneten Reihen von Ueberspannungsbegrenzern (28) auf der anderen Seite der Filterplatte (19) angeordnet sind und gegenüber der ersten Reihe um eine halbe Teilung versetzt sind.

5. Steuergerät nach einem der Ansprüche 1 bis 4, **dadurch gekennzeichnet**, dass die ersten Stifte (29) der beiden einem Stecker zugeordneten Reihen, statt mit einer Leitung und mit einem Ueberspannungsbegrenzer (27, 28), über Leiterbahnen (59, 60, 61) mit je einem Pol einer Spannungsversorgung verbunden sind, die auf der zugeordneten Schnittstellenkarten (14) angeordnete, vom Mikroprozessor durch die Optokoppler galvanisch getrennte, Elemente, wie Spulen von Ausgangsrelais oder A/D-Wandler, speist.

6. Steuergerät nach einem der Ansprüche 1 bis 5, dadurch gekennzeichnet, dass die Filterplatte (19) beidseitig mit Leiterbahnen versehen ist, wobei gegenüberliegende Leiterbahnen durch mehrfache Durchkontaktierung parallel geschaltet sind.

7. Steuergerät nach einem der Ansprüche 1 bis 6, **dadurch gekennzeichnet,** dass die einem Stecker (18) zugeordneten Stifte (29) auf der Leitungsseite in Durchgangsöffnungen eines zweiten Steckergehäuses (25) ragen, in die von der anderen Seite auf die Leitungen gepresste Crimpkontaktstücke eingesteckt werden, welche mit den Stiften (29) Kontakt machen.

8. Steuergerät nach Anspruch 7, **dadurch gekennzeichnet,** dass die zweiten Steckergehäuse (25) in Durchbrüchen der Gehäuserückwand (5) befestigt sind.

## Claims

1. Control unit with microprocessor for medium and high voltage switchgear, which is installed in a housing designed as a Faraday cage and is connected via electrical measuring and control lines to the drives of the switching devices and to the measuring transformers of the switchgear, the lines being electrically isolated from the microprocessor system by means of optocouplers, characterized by the following features:
a) the lines are taken on the one side of a filter plate (19), comprising a printed circuit (31), onto pins (29) penetrating the said filter plate and arranged in rows;
b) fitted on the other side of the filter plate (19) there are connectors (18) with rows of contact members, which contact members are each aligned with a pin (29) and are electrically connected to the latter;
c) inserted into these connectors (18) by a first end face are interface cards (14), which bear the opto-couplers and are connected on the opposite second end face by means of a multipoint connector (15) to a bus leading to the processor;
d) the filter plate (19) is provided on its entire periphery with a bare edge conductor path (32, 33, 34, 35; 36, 37, 38, 39), which over its entire length contacts the housing;
e) between every two rows of pins (29) there runs in each case a further conductor path (40, 41; 42, 43), which is connected at both its ends to the edge conductor path (32, 33, 34, 35; 36, 37, 38, 39);
f) each of the pins (29) of a row is connected by means of in each case one conductor path (49, 50; 51, 52) of the filter plate (19) to the first terminals of surge arresters (27, 28), which are arranged in rows running parallel to the rows of the pins (29) and the second terminals of which are connected directly or via one of the further conductor paths (41, 43) to the edge conductor path (32, 33, 34, 35; 36, 37, 38, 39).

2. Control unit according to Claim 1, characterized in that the surge arresters (27, 28) are capacitors.

3. Control unit according to Claim 1 or 2, characterized in that the pins (29), the contact members and the insulating housing of each connector (18) are inseparably interconnected, so that the pins (29) at the same time form the fastening means for the connectors (18) on the filter plate (19).

4. Control unit according to one of Claims 1 to 3, characterized in that the connectors (18) have two rows of contact members, and the rows of surge arresters (27) assigned to the first rows of contact members are arranged on one side of the filter plate (19), the rows of surge arresters (28) assigned to the other rows of contact members are arranged on the other side of the filter plate (19) and are offset with respect to the first row by half a division.

5. Control unit according to one of Claims 1 to 4, characterized in that, instead of being connected to a line and to a surge arrester (27, 28), the first pins (29) of the two rows assigned to a connector are connected via conductor paths (59, 60, 61) to one pole each of a voltage supply, which feeds elements, such as coils of output relays or A/D converters, which are arranged on the assigned interface cards (14) and are electrically isolated from the microprocessor by the optocouplers.

6. Control unit according to one of Claims 1 to 5, characterized in that the filter plate (19) is provided on both sides with conductor paths, opposing conductor paths being connected in parallel by multiple plating-through.

7. Control unit according to one of Claims 1 to 6 characterized in that the pins (29) assigned to a connector (18) on the line side protrude into passage openings of a second connector housing (25), into which pressed crimp contact members are inserted from the other side onto the lines and make contact with the pins (29).

8. Control unit according to Claim 7, characterized in that the second connector housings (25) are fastened in openings in the housing rear wall (5).

## Revendications

1. Dispositif de commande à microprocesseur pour installations de commutation à moyenne et à haute tension, qui est monté dans un boîtier réalisé sous forme de cage de Faraday et qui est relié par des lignes de mesure et de commande aux entraînements commande des commutateurs et aux transformateurs de mesure de l'installation de commutation, les lignes étant séparées galvaniquement du système à microprocesseur au moyen de coupleurs optiques, caractérisé en ce que
a) les lignes sont amenées, sur le premier côté d'une plaque de filtre (19) qui est composée d'un circuit imprimé (31), sur des broches (29) disposées en rangées et traversant cette plaque;
b) sur l'autre côté de la plaque de filtre (19) sont montées des connecteurs à enficher (18) pourvus de rangées d'éléments de contact, chacun de ces éléments de contact étant aligné avec une broche (29) et lui étant relié électriquement;
c) dans ces connecteurs à enficher (18) sont enfichées, par une première face frontale, des cartes d'interface (14) qui portent les coupleurs optiques et qui sont reliées sur la deuxième face frontale opposée par un connecteur mâle multiple à enficher (15) à un bus conduisant vers le processeur;
d) la plaque de filtre (19) est pourvue, sur toute sa périphérie, d'une bande conductrice marginale dénudée (32, 33, 34, 35; 36, 37, 38, 39) qui est en contact sur toute sa longueur avec le boîtier;
e) entre deux rangées respectives de broches (29) est tracée une autre bande conductrice (40, 41; 42, 43) qui est reliée à ses deux extrémités à la bande conductrice marginale (32, 33, 34, 35; 36, 37, 38, 39);
f) chacune des broches (29) d'une rangée est reliée au moyen d'une bande conductrice respective (49, 50; 51, 52) de la plaque de filtre (19) aux premières connexions de limiteurs (27, 28) de surtension qui sont disposés en rangées tracées en parallèle aux rangées des broches (29) et dont les deuxièmes connexions sont reliées, directement ou par l'une des autres bandes conductrices (42, 43), à la bande conductrice marginale (32, 33, 34, 35; 36, 37, 38, 39).

2. Dispositif de commande selon la revendication 1, caractérisé en ce que les limiteurs (27, 28) de surtension sont des condensateurs.

3. Dispositif de commande selon la revendication 1 ou 2, caractérisé en ce que les broches (29), les éléments de contact et le boîtier isolant de chaque connecteur à enficher (18) sont reliés entre eux de façon inséparable, de sorte que les broches (29) constituent en même temps le moyen de fixation des connecteurs à enficher (18) à la plaque de filtre (19).

4. Dispositif de commande selon l'une des revendications 1 à 3, caractérisé en ce que les connecteurs à enficher (18) comportent deux rangées d'éléments de contact et les rangées de limiteurs (27) de surtension associées aux premières rangées d'éléments de contact sont disposées sur un premier côté de la plaque de filtre (19), les rangées de limiteurs (28) de surtension associées aux autres rangées d'éléments de contact sont disposées sur l'autre côté de la plaque de filtre (19) et sont décalées d'une demi division par rapport à celles de la première rangée.

5. Dispositif de commande selon l'une des revendications 1 à 4, caractérisé en ce que les premières broches (29) des deux rangées associées à un connecteur à enficher, au lieu d'être reliées à une ligne et à un limiteur (27, 28) de surtension, sont reliées par des bandes conductrices (59, 60, 61) chacune à un pôle d'une alimentation en tension qui alimente les éléments disposés sur la carte d'interface associée (14) et séparés galvaniquement du microprocesseur par les coupleurs optiques, par exemple des bobines de relai de sortie ou des convertisseurs A/N.

6. Dispositif de commande selon l'une des revendication 1 à 5, caractérisé en ce que la plaque de filtre (19) est pourvue de bandes conductrices sur chaque côté, des bandes conductrices opposées étant reliées en parallèle par de multiples contacts traversants.

7. Dispositif de commande selon l'une des revendications 1 à 6, caractérisé en ce que les broches (29) associées à une connecteur à enficher (18) font saillie sur le côté de ligne dans des ouvertures de passage d'un deuxième boîtier (25) de connecteur à enficher dans lesquelles sont enfichés, depuis l'autre côté, des éléments de contact à sertissage crimp serrés sur les lignes, éléments qui font contact avec les broches (29).

8. Dispositif de commande selon la revendication 7, caractérisé en ce que les deuxièmes boîtiers (25) de connecteurs à enficher sont fixés dans des orifices ménagés dans la paroi arrière (5) du boîtier.
